Europäisches Patentamt

European Patent Office

Office européen des brevets

(19)

(11) Numéro de publication: **0 261 040 B1**

(12) **FASCICULE DE BREVET EUROPEEN**

(45) Date de publication de fascicule du brevet:
27.11.91

(51) Int. Cl.5: **H01L 21/311, H01L 21/306**

(21) Numéro de dépôt: 87420224.5

(22) Date de dépôt: 25.08.87

(54) **Procédé de gravure localisée d'une couche d'oxyde de silicium.**

(30) Priorité: 26.08.86 FR 8612296

(43) Date de publication de la demande:
23.03.88 Bulletin 88/12

(45) Mention de la délivrance du brevet:
27.11.91 Bulletin 91/48

(84) Etats contractants désignés:
BE DE GB IT NL

(56) Documents cités:

IBM TECHNICAL DISCLOSURE BULLETIN, vol.
22, no. 3, août 1979, page 1235, New York,
US; V.J. SILVESTRI: "Silane as etchant in
plasma systems"

(73) Titulaire: **ETAT FRANCAIS repr. par le Secrétaire d'Etat aux Postes & Télécommunications (Centre National d'Etudes des Télécommunications)**
**38-40 Rue du Général Leclerc**
**F-92131 ISSY LES MOULINEAUX(FR)**

(72) Inventeur: **Auvert, Geoffroy**
**22 Rue Barnave**
**F-38000 Grenoble(FR)**
Inventeur: **Pauleau, Yves**
**15 Rue de Stalingrad**
**F-38100 Grenoble(FR)**
Inventeur: **Tonneau, Didier**
**71 Rue Nicolas Chorier**
**F-38000 Grenoble(FR)**

(74) Mandataire: **de Beaumont, Michel**
**1bis, rue Champollion**
**F-38000 Grenoble(FR)**

## Description

La présente invention concerne le domaine de la fabrication des composants semiconducteurs, par exemple des circuits intégrés.

Dans le domaine de la fabrication des circuits intégrés, on cherche souvent à réaliser des ouvertures localisées de petites dimensions dans une couche de silice ($SiO_2$), par exemple quand on effectue des opérations de test sous pointes et que l'on souhaite mettre une pointe en contact avec une zone particulière d'une couche sous-jacente. On cherche alors à réaliser des ouvertures aussi petites que possible sans affecter le reste de la tranche

Jusqu'à présent, les procédés pour réaliser de telles ouvertures sont les procédés classiques de photolithogravure qui consistent à déposer une résine, insoler cette résine, révéler cette résine, graver par exemple par plasma, et enlever la résine. Cette succession d'étapes est relativement longue et entraîne des risques de dégradation de parties non souhaitée de la tranche, par exemple si la résine présente des défauts.

Ainsi, la présente invention vise un procédé de gravure localisée d'une couche de silice éventuellement épaisse qui n'entraîne aucun risque de dégradation d'autres zones d'une tranche semiconductrice et qui permet de faire des ouvertures bien localisées et de petites dimensions.

Pour atteindre ces objets ainsi que d'autres, la présente invention prévoir un procédé de gravure localisée d'une couche d'oxyde de silicium ($SiO_2$) comprenant les étapes consistant à placer un substrat portant la couche dans une enceinte à une pression inférieure à environ $10^2$ Pascal en présence de silane ($SiH_4$), et à chauffer ponctuellement la zone à graver, par exemple par irradiation au moyen d'un faisceau laser.

On notera que des techniques de traitement de semiconducteur par irradiation par des faisceaux laser en présence de silane sont connues, par exemple à partir des documents "Ar$^+$ laser induced chemical vapor deposition of Si from $SiH_4$" de D. Bäuerle et al. - Appl. Phys. Lett. 40(9), premier mai 1982, et "Laser microreaction for deposition of doped silicon films" de D.J. Ehrlich et al., Appl. Phys. Lett. 39(12), 15 décembre 1981.

Dans le premier document, on étudie un phénomène se produisant à 133 millibars soit 1,33 $10^4$ Pa.

Dans le deuxième document, on mentionne des pressions de silane allant de 1 à 200 torrs, c'est-à-dire de 133 à 2,66 $10^4$ Pa et tous les exemples sont donnés pour des pressions de 100 à 200 torr (1,33 à 2,66 $10^4$ Pa).

Dans les deux documents, on enseigne qu'en présence de silane, il se produit des dépôts de silicium dans des zones irradiées par un faisceau laser. Il est tout particulièrement intéressant de noter dans le deuxième document que ces dépôts de silicium se produisent au-dessus de couches de $SiO_2$ qui, apparemment, ne sont pas affectées par l'irradiation laser.

Au contraire, selon la présente invention, il a été découvert que pour une pression très faible, inférieure à environ 100 Pa il se produit une attaque du $SiO_2$ dans des emplacements irradiés par un faisceau laser au lieu d'un dépôt de silicium sur le $SiO_2$.

La présente invention va être illustrée plus particulièrement en relation avec des exemples.

## EXEMPLE 1.

Etant donné une couche de silicium revêtue d'une couche de $SiO_2$ d'une épaisseur comprise entre 1 et 10000 nm, et en effectuant une irradiation par un laser à argon fonctionnant en continu à une longueur d'onde de 500 nm, on a obtenu des trous localisés d'un diamètre de l'ordre de 1000 nm, la tache de focalisation ayant une dimension de l'ordre de 500 nm.

## EXEMPLE 2.

Dans le cas de couches de $SiO_2$ d'une épaisseur du dixième de millimètre à 2 mm, on a obtenu avec un laser à $CO_2$ à une longueur d'onde de 10 $\mu$m fonctionnant en continu des ouvertures d'un diamètre régulier de l'ordre de 50 $\mu$m.

On notera en particulier dans ce deuxième exemple la régularité des trous obtenus. Ceci est dû au phénomène de canal optique que produit le trou en cours de formation dans la silice.

Bien entendu, à condition de disposer d'une énergie suffisante, on peut utiliser un laser en impulsion. Pour des trous de plus grande dimension, au lieu de focaliser fortement le laser en un point, on peut utiliser un laser plus puissant défocalisé, la tache de focalisation ayant un diamètre allant jusqu'à 20 $\mu$m ; et, pour augmenter encore la dimension des ouvertures, on peut procéder à un balayage du faisceau laser sur la surface à traiter.

Dans le cas des deux exemples ci-dessus, la puissance du laser était choisie selon la nature du substrat dans une gamme de 1 à 20 watts. La vitesse de gravure varie avec les conditions de fonctionnement dans une plage de 1 à 10 $\mu$m/minute.

## Revendications

1. Procédé de gravure localisée d'une couche d'oxyde de silicium ($SiO_2$), caractérisé en ce qu'il comprend les étapes suivantes :

- placer un substrat portant la couche d'oxyde dans une enceinte à une pression inférieure à environ $10^2$ Pa en présence de silane ($SiH_4$),
- chauffer ponctuellement la zone à graver.

2. Procédé de gravure localisée d'une couche d'oxyde de silicium selon la revendication 1, caractérisé en ce que le chauffage ponctuel est réalisé au moyen d'un faisceau laser.

3. Procédé de gravure localisée d'une couche d'oxyde de silicium selon la revendication 2, caractérisé en ce que le laser est un laser à $CO_2$ fonctionnant à une longueur d'onde de 10 micromètres.

4. Procédé de gravure localisée d'une couche d'oxyde de silicium selon la revendication 2, caractérisé en ce que le laser est un laser à argon fonctionnant à une longueur d'onde de 0,5 micromètres.

5. Procédé de gravure localisée d'une couche d'oxyde de silicium selon l'une quelconque des revendications 2 à 4, caractérisé en ce qu'il consiste en outre à effectuer un balayage du faisceau laser sur la surface du substrat portant la couche.

## Claims

1. A method for locally etching away a silicon dioxide ($SiO_2$) layer, characterized in this that it comprises the following steps:
    - arranging a substrate carrying said oxide layer in a housing at a pressure lower than about $10^2$ Pa in the presence of silane ($SiH_4$),
    - punctually heating the area to be etched away.

2. A method for locally etching away a silicon dioxide layer according to claim 1, characterized in this that the punctual heating is carried out by a laser beam.

3. A method for locally etching away a silicon dioxide layer according to claim 2, characterized in this that said laser is a c.w. $CO_2$ laser operating at a wavelength of 10 micrometers.

4. A method for locally etching away a silicon dioxide layer according to claim 2, characterized in this that said laser is a c.w. argon laser operating at a wavelength of 0.5 micrometer.

5. A method for locally etching away a silicon dioxide layer according to any of claims 2 to 4, characterized in this that it further comprises the step of scanning the laser beam onto the surface of the substrate supporting said layer.

## Patentansprüche

1. Verfahren zum lokalisierten Ätzen einer Siliziumoxidschicht ($SiO_2$), gekennzeichnet durch die folgenden Schritte:
    - ein Substrat, das die Oxidschicht trägt, wird in einem Gehäuse mit einem Innendruck von niedriger als etwa $10^2$ Pa in Gegenwart von Silan ($SiH_4$) plaziert und
    - die zu ätzende Zone wird punktuell aufgeheizt.

2. Verfahren zum lokalisierten Ätzen einer Siliziumoxidschicht nach Anspruch 1, dadurch gekennzeichnet, daß das punktuelle Aufheizen mit Hilfe eines Laserstrahles realisiert wird.

3. Verfahren zum lokalisierten Ätzen einer Siliziumoxidschicht nach Anspruch 2, dadurch gekennzeichnet, daß der Laser ein $CO_2$-Laser ist, der bei einer Wellenlänge von 10 Mikrometern arbeitet.

4. Verfahren zum lokalisierten Ätzen einer Siliziumoxidschicht nach Anspruch 2, dadurch gekennzeichnet, daß der Laser ein Argon-Laser ist, der bei einer Wellenlänge von 0,5 Mikrometern arbeitet.

5. Verfahren zum lokalisierten Ätzen einer Siliziumoxidschicht nach einem der Ansprüche 2 bis 4, dadurch gekennzeichnet, daß zusätzlich die Oberfläche des die Oxidschicht tragenden Substrats mit dem Laserstrahl überstrichen wird.